**Europäisches Patentamt**

**European Patent Office**

**Office européen des brevets**

(19)

(11) Veröffentlichungsnummer : **0 331 892 B1**

(12)

# EUROPÄISCHE PATENTSCHRIFT

(45) Veröffentlichungstag der Patentschrift :
01.04.92 Patentblatt 92/14

(51) Int. Cl.⁵ : **H01L 29/74**

(21) Anmeldenummer : **89101394.8**

(22) Anmeldetag : **27.01.89**

(54) **Mos-gesteuerter Thyristor (MCT).**

(30) Priorität : **10.03.88 CH 903/88**

(43) Veröffentlichungstag der Anmeldung :
**13.09.89 Patentblatt 89/37**

(45) Bekanntmachung des Hinweises auf die
Patenterteilung :
**01.04.92 Patentblatt 92/14**

(84) Benannte Vertragsstaaten :
**AT BE CH DE FR GB IT LI NL SE**

(56) Entgegenhaltungen :
**EP-A- 0 199 293**

(56) Entgegenhaltungen :
**DE-A- 2 625 917**
**GB-A- 2 124 428**
**SIEMENS FORSCHUNGS- UND ENTWICK-**
**LUNGSBERICHTE, Band 14, Nr. 2, 1985, Seiten**
**45-49, Springer-Verlag, Berlin, DE; M. STOI-**
**SIEK et al.: "Power devices with MOS-**
**controlled emitter shorts"**

(73) Patentinhaber : **ASEA BROWN BOVERI AG**
**Haselstrasse**
**CH-5401 Baden (CH)**

(72) Erfinder : **Bauer, Friedhelm, Dr.**
**Breitenstrasse 9**
**CH-5303 Würenlingen (CH)**

# EP 0 331 892 B1

## Beschreibung

### TECHNISCHES GEBIET

Die vorliegende Erfindung bezieht sich auf das Gebiet der Leistungselektronik. Sie betrifft insbesondere einen MOS-gesteuerten Thyristor (MCT) mit einer Anode und einer Kathode, umfassend
– zwischen der Anode und der Kathode eine Folge unterschiedlich dotierter Schichten mit einer p-Emitterschicht, einer n-Basisschicht, einer p-Basisschicht und einer n-Emitterschicht; und
– kathodenseitig eine Mehrzahl von Kathodenkurzschlüssen, welche jeweils über eine MOSFET-Struktur mit einem Sourcegebiet, einem Kanalgebiet, einem Draingebiet und einer isolierten Gateelektrode steuerbar sind, und im eingeschalteten Zustand die p-Basisschicht mit einem Kathodenkontakt kurzschliessen; wobei
– die p-Basisschicht mit dem Draingebiet über einen Drainkontakt verbunden ist, und das Sourcegebiet ein Teil der mit dem Kathodenkontakt in Verbindung stehenden n-Emitterschicht ist.

Ein solcher Thyristor ist z.B. aus dem Artikel von M.Stoisiek et al., IEEE int. Electron Dev. Meet. Techn. Dig., S. 158-161 (1985), bekannt.

### STAND DER TECHNIK

Feldeffektgesteuerte bipolare Leistungshalbleiter-Bauelemente gewinnen in der Leistungselektronik zunehmend an Bedeutung, weil sie den für bipolare Bauelemente typischen niedrigen Durchlasswiderstand mit der leistungslosen Steuerung der Leitfähigkeit einer Halbleiteroberfläche über eine isolierte Gateelektrode kombinieren.

Mit dem IGT (Insulated Gate Transistor) hat sich bereits ein erster Vertreter derartiger Bauelemente für Anwendungen über 500 V etabliert (siehe dazu: B.J. Baliga et al., IEEE Int. Electron Dev. Meet. Techn. Dig., S. 264-267 (1982); oder: J.P. Russell et al., IEEE Electron Dev. Lett., EDL-4, S. 62-65 (1983)).

Diese neuen Bauelemente für die 1000 V-Klasse finden grosse Beachtung von Seiten der Schaltungsentwickler, weil bei ihnen besonders einfache und deshalb preisgünstige Ansteuerschaltungen realisiert werden können.

Für noch höhere Spannungen bietet sich anstelle der Transistor- eine Thyristorstruktur an, bei welcher Kathodenkurzschlüsse über MOSFET-Strukturen geschaltet werden können.

Solche MOS-gesteuerten Thyristoren oder MCTs (MOS Controlled Thyristors) sind bereits verschiedentlich vorgeschlagen worden (V.A.K. Temple, IEEE Trans. Electron Dev., ED-33, S. 1609-1618 (1986), oder die eingangs zitierte Druckschrift).

Der einfachste abschaltbare MCT verwendet eine DMOS-ähnliche p-Kanal-Elementarzelle (siehe Fig. 8 in dem Artikel von V.A.K. Temple). Wegen der vergleichsweise kleinen Beweglichkeit von Löchern in Inversionsschichten (das Verhältnis der Beweglichkeiten zwischen p-Kanal- und n-Kanal-MOSFET beträgt etwa 1:3) kann ein p-Kanal-MCT jedoch maximal nur ein Drittel der Stromdichten eines vergleichbaren n-Kanal-MCT abschalten.

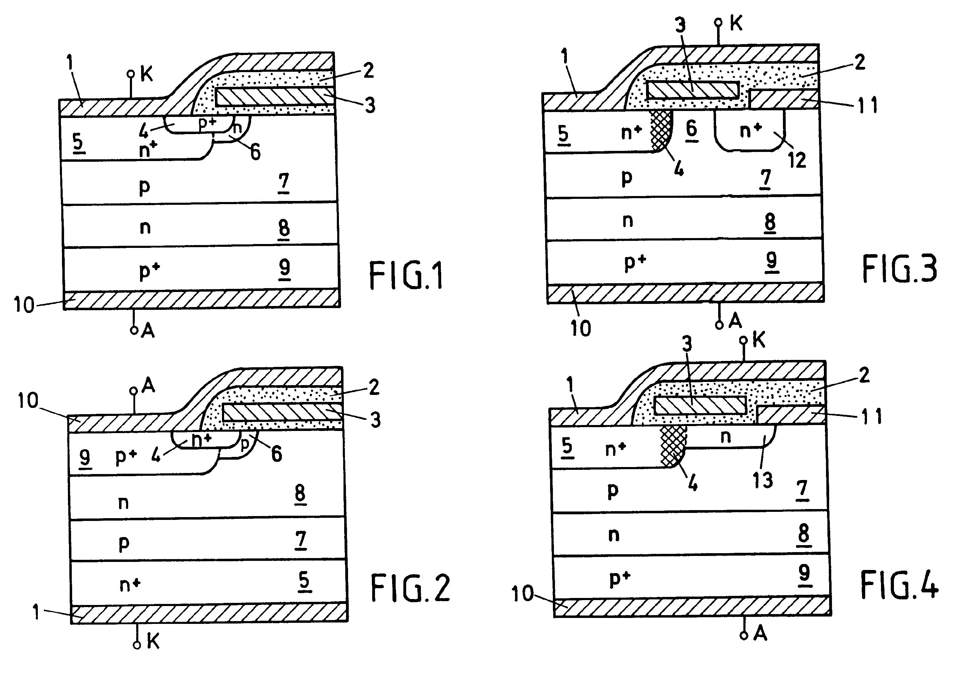

Ein n-Kanal-MCT lässt sich ähnlich wie in der CMOS-Technologie durch Aufbau einer zum p-Kanal-MCT komplementären Struktur realisieren (siehe Fig. 2 in dem Artikel von V.A.K. Temple). Hierfür ist allerdings epitaktisch aufgewachsenes Substratmaterial notwendig. Mit der Festlegung auf ein p-dotiertes Ausgangsmaterial mit n-Epitaxie-Schichten sind aber alle wichtigen Vorteile, welche die Verwendung von Neutronen-dotiertem (NTD-) Silizium bei der Fertigung von Leistungshalbleiter-Bauelementen bringt, hinfällig.

Eine andere Möglichkeit zur Realisierung eines n-Kanal-MCT, die ohne epitaktisches Substratmaterial auskommt, ist aus der eingangs zitierten Druckschrift bekannt (Fig. 1b). Für die Herstellung kann hier n-dotiertes NTD-Silizium verwendet werden.

Die Struktur erfordert jedoch viel Platz. Deshalb kann der Vorteil der höheren Kanalbeweglichkeit gegenüber dem p-Kanal-MCT nicht voll ausgeschöpft werden. Vielmehr wurden experminetell für beide MCT-Typen etwa die gleichen maximal abschaltbaren Stromstärken gefunden.

Eine Erhöhung der maximal abschaltbaren Stromstärke, welche aus Gründen der Minimierung der Ansteuerleistung wünschenswert ist, kann beim n-Kanal-MCT durch eine Reduzierung des Widerstandes im Kurzschlusspfad des MCT erreicht werden.

Die dominierende Komponente in diesem Kurzschlusspfad stellt aber der Kanalwiderstand der MOSFET-Struktur dar. Diese Komponente kann am wirkungsvollsten durch die Reduzierung der Kanallänge verkleinert werden.

Andererseits enthält die MOSFET-Struktur im n-Kanal-MCT aus der eingangs genannten Druckschrift auch eine parasitäre Bipolarstruktur, bestehend aus der n-Emitterschicht, der p-Basisschicht und dem zusätzlichen

$n^+$-dotierten Draingebiet, welches die Funktion des Kolektors übernimmt.

Rastet dieser parasitäre BJT ein, verliert das Gate seine Steuerwirkung auf den Inversionskanal; der MCT kann dann nicht mehr abgeschaltet werden. Dieser Prozess wird durch diejenigen Löcher getriggert, welche innerhalb der p-Basisschicht unterhalb des Kanals der n-Emitterschicht zufliessen (siehe dazu: M.Stoisiek et al., Advances in Solid State Physics, Vol. 26, S. 361 - 373, F.Vieweg + Sons, Braunschweig/Wiesbaden (1986)).

## DARSTELLUNG DER ERFINDUNG

Aufgabe der vorliegenden Erfindung ist es nun, einen n-Kanal-MCT zu schaffen, der einerseits frei ist von Einrastproblemen, und andererseits eine Erhöhung der maximal abschaltbaren Stromstärke erlaubt.

Die Aufgabe wird bei einem Thyristor der eingangs genannten Art dadurch gelöst, dass zwischen dem Sourcegebiet und dem Drainkontakt ein kombiniertes Kanal-Drain-Gebiet in Form einer n-dotierten Zone angeordnet ist.

Der Kern der Erfindung besteht darin, anstelle der MOSFET-Struktur mit Inversionskanal eine MOSFET-Struktur vom Verarmungstyp (depletion MOSFET) einzusetzen. Auf diese Weise werden parasitäre BJT-Strukturen vermieden.

Da der erfindungsgemässe n-Kanal-MCT somit frei von den vorher erwähnten Einrastproblemen ist, kann das Prinzip der minimierung der Kanallänge nunmehr ohne Begrenzung angewendet werden, um die maximal abschaltbare Stromstärke zu erhöhen.

Gemäss einem bevorzugten Ausführungsbeispiel der Erfindung ist die n-Dotierung des kombinierten Kanal-Drain-Gebiets so gewählt, dass das Gebiet bei an der Gateelektrode anliegender Spannung in seiner gesamten Tiefe ausgeräumt werden kann.

Auf diese Weise kann der Stromfluss zwischen Source und Drain vollständig unterbunden werden, so dass die Kurzschlüsse keinerlei Wirkung mehr haben.

Weitere Ausführungsbeispiele ergeben sich aus den Unteransprüchen.

## KURZE BESCHREIBUNG DER ZEICHNUNG

Die Erfindung soll nachfolgend anhand von Ausführungsbeispielen im Zusammenhang mit der Zeichnung näher erläutert werden. Es zeigen:

Fig. 1 im Ausschnitt die Struktur eines p-Kanal-MCT nach dem Stand der Technik;
Fig. 2 die Struktur eines ersten n-Kanal-MCT nach dem Stand der Technik;
Fig. 3 die Struktur eines zweiten n-Kanal-MCT nach dem Stand der Technik; und
Fig. 4 die Struktur eines verbesserten n-Kanal-MCT gemäss einem Ausführungsbeispiel der Erfindung.

## WEGE ZUR AUSFÜHRUNG DER ERFINDUNG

In den Figuren 1 - 3 sind verschiedene bekannte MCT-Strukturen ausschnittsweise dargestellt.

Fig. 1 zeigt einen p-Kanal-MCT, der mit n-dotiertem Silizium-Grundmaterial, insbesondere also mit dem bevorzugten NTD-Silizium, hergestellt werden kann.

Die Thyristorstruktur umfasst bei diesem MCT zwischen einer Anode A und einer Kathode K eine Folge von Schichten, die sich aus einer $p^+$-dotierten p-Emitterschicht 9, einer n-dotierten n-Basisschicht 8, einer p-dotierten p-Basisschicht 7 und einer $n^+$-dotierten n-Emitterschicht 5 zusammensetzt. Die p-Emitterschicht 9 ist mit einem Anodenkontakt 10, die n-Emitterschicht 5 mit einem Kathodenkontakt 1 versehen.

Der steuerbare Kathodenkurzschluss zwischen der p-Basisschicht 7 und dem Kathodenkontakt 1 wird von einer MOSFET-Struktur gebildet, die aus einem $p^+$-dotierten Sourcegebiet 4, einem n-dotierten Kanalgebiet 6, dem an die Substratoberfläche tretenden Teil der p-Basisschicht 7 und einer darüberliegenden Gateelektrode 3 besteht. Die Gateelektrode 3 ist dabei durch eine Gateisolierung 2 vom Substrat und vom Kathodenkontakt 1 elektrisch isoliert.

Wird nun eine geeignete Spannung an die Gateelektrode 3 angelegt, bildet sich im Kanalgebiet 6 an der Substratoberfläche ein p-leitender Inversionskanal, der die p-Basisschicht 7 leitend mit dem Kathodenkontakt 1 verbindet. In diesem Falle ist daher jeder der Kathodenkurzschlüsse wirksam.

Liegt keine Spannung an der Gateelektrode 3 an, sind die Kathodenkurzschlüsse unwirksam, und das Bauelement zeigt das Verhalten einer normalen Thyristorstruktur. Wegen weiterer Einzelheiten der Funktionsweise wird auf die zitierten Druckschriften verwiesen.

Wie bereits eingangs erwähnt, ist es hinsichtlich der maximal abschaltbaren Stromstärke günstiger, anstelle eines p-Kanal-MCT einen n-Kanal-MCT einzusetzen.

Eine erste bekannte Möglichkeit, einen solchen n-Kanal-MCT zu realisieren, besteht darin, den MCT in einer zu Fig. 1 komplementären Struktur aufzubauen, d.h. die p- und n-dotierten Schichten und Gebiete zu vertauschen.

Ein solcher zum p-Kanal-MCT der Fig. 1 komplementärer n-Kanal-MCT ist in Fig. 2 dargestellt. Anordnung und Funktionsweise dieser MCT sind analog, mit dem Unterschied, dass Anode und Kathode vertauscht sind und der Inversionskanal nunmehr ein n-Kanal ist.

Während beim p-Kanal-MCT der Fig. 1 jedoch ein n-dotiertes Substratmaterial verwendet werden kann, in das nacheinander die Schichten 7, 9 und 5 eindiffundiert werden, muss beim n-Kanal-MCT der Fig. 2 zu einem epitaktischen Aufbau der Schichtenfolge gegriffen werden, was technologisch wesentlich aufwendiger ist und nur unter Schwierigkeiten zu der gewünschten Homogenität führt.

Deshalb ist bereits vorgeschlagen worden, den n-Kanal-MCT so aufzubauen, dass auch hier n-dotiertes Ausgangsmaterial verwendet werden kann. Die vorgeschlagene Struktur ist in Fig. 3 wiedergegeben.

Die zur Steuerung der Kathodenkurzschlüsse notwendige MOSFET-Struktur umfasst bei diesem n-Kanal-MCT ein $n^+$-dotiertes Sourcegebiet 4, welches Teil der n-Emitterschicht 5 ist, ein Kanalgebiet 6, welches Teil der p-Basisschicht 7 ist, ein $n^+$-dotiertes Draingebiet 12 und die darüberliegende Gateelektrode 13.

Die p-Basisschicht 7 ist über einen Drainkontakt 11 an das Draingebiet 12 angeschlossen und wird mit dem Kathodenkontakt 1 kurzgeschlossen, wenn eine geeignete Spannung an der Gateelektrode 3 im Kanalgebiet 6 einen n-leitenden Inversionskanal erzeugt.

Bei dieser bekannten MCT-Struktur treten jedoch zwei Probleme auf: Zum einen bilden die n-Emitterschicht, die p-Basisschicht 7 ausserhalb des Kanalgebiets 6 und das Draingebiet 12 eine parasitäre bipolare npn-Transistorstruktur, die unter bestimmten Bedingungen zu einem Einrasten (latch-up) und damit zum Verlust der Steuerfähigkeit für die Kurzschlüsse führt. Das Kanalgebiet 6 sollte daher möglichst breit gewählt werden, um die Wirkung dieser parasitären Struktur klein zu halten.

Zum anderen bedeutet aber eine grosse Breite des Kanalgebietes 6 einen hohen Kanalwiderstand, der sich begrenzend auf die maximal abschaltbare Stromstärke auswirkt.

Um dieses Dilemma aufzulösen, wird gemäss der Erfindung nun vorgeschlagen, zwischen dem Drainkontakt 11 und der n-Emitterschicht 5 ein n-dotiertes kombiniertes Kanal-Drain-Gebiet 13 anzuordnen, das an die Stelle des Kanalgebiets 6 und des Draingebiets 13 tritt (Fig. 4).

Durch dieses kombinierte Kanal-Drain-Gebiet 13 wird die MOSFET-Struktur vom Anreicherungs-Typ (enhancement-FET) in einen Verarmungs-Typ (depletion-FET) umgewandelt.

Die Folge dieser Umwandlung ist, dass die MOSFET-Steuerung nicht länger durch eine parasitäre Bipolarstruktur beeinträchtigt wird. Entsprechend kann nun die Kanallänge so klein wie möglich gewählt werden, so dass das Potential des n-Kanal-MCT bezüglich der maximal abschaltbaren Stromstärke voll ausgeschöpft werden kann.

In der vorgeschlagenen Struktur (Fig. 4) besitzt der Randbereich der n-Emitterschicht 5 weiterhin die Funktion des Sourcegebietes 4. Das Kanal- und Draingebiet besteht aus dem n-dotierten kombinierten Kanal-Drain-Gebiet 13. Ueber einem Teil dieses Gebietes befindet sich die isolierte Gateelektrode 3.

Ueber das Gatepotential kann die Leitfähigkeit des kombinierten Kanal-Drain-Gebiets 13 in weiten Grenzen variiert werden. Die Dotierung dieses Gebiets wird dabei vorzugsweise so gewählt, dass das Gebiet in seiner ganzen Tiefe ausgeräumt werden kann.

Zwischen Source und Drain findet dann kein Stromfluss statt und die MOSFET-Struktur sperrt. Dieser Zustand wird bei den typischen Materialien für Gateelektrode (Poly-Silizium) und Gateisolierung ($SiO_2$) bei gegenüber der n-Emitterschicht 5 negativen Gatespannungen erzielt.

Die Funktionsweise der MOSFET-Struktur entspricht damit, wie bereits mehrfach erwähnt, derjenigen eines n-Kanal-MOSFET vom Verarmungstyp (siehe dazu: C. Turchetti et al., IEEE Trans. Electron Dev., ED-32, S. 773-782 (1985)). Dementsprechend besitzt der Kanal bei einer Gatespannung von 0 V gegenüber der n-Emitterschicht 5 eine gute Leitfähigkeit. Diese kann durch eine Erhöhung der Gatespannung zu positiven Werten noch wesentlich gesteigert werden, was der Wirksamkeit der Kurzschlüsse zugutekommt.

In der vorgeschlagenen Struktur wird auf die $n^+$-Dotierung des Draingebietes verzichtet. Da die Dotierung des kombinierten Kanal-Drain-Gebietes 13 vorzugsweise im Bereich von $10^{17}$ cm$^{-3}$ liegt, sind auch bei direkter Metallisierung (für den Drainkontakt 11) akzeptable Kontakteigenschaften zu erreichen.

Gemäss einem anderen Ausführungsbeispiel der Erfindung kann der Drainkontakt 11 auch als Metallsilizid-Schicht auf das Substrat aufgebracht werden, so dass der Kontakt auf n-Silizium dann die Eigenschaften einer Schottkybarriere erhält. Einzelheiten zu dieser Kontaktierungsart können einem Artikel von S.E. Swirhun et al., IEEE Trans. Electron Dev., ED-32, S. 194 - 202 (1985) entnommen werden.

Insgesamt wird mit der erfindungsgemässen Struktur ein n-Kanal-MCT zur Verfügung gstellt, der keine Einrastprobleme kennt und zugleich hinsichtlich der maximal abschaltbaren Stromstärke leicht optimiert werden kann.

**Patentansprüche**

1. MOS-gesteuerter Thyristor (MCT) mit einer Anode (A) und einer Kathode (K), umfassend

(a) zwischen der Anode (A) und der Kathode (K) eine Folge unterschiedlich dotierter Schichten mit einer p-Emitterschicht (9), einer n-Basisschicht (8), einer p-Basisschicht (7) und einer n-Emitterschicht (5); und

(b) kathodenseitig eine Mehrzahl von Kathodenkurzschlüssen, welche jeweils über eine MOSFET-Struktur, mit einem Sourcegebiet (4), einem Kanalgebiet, einem Draingebiet und einer isolierten Gateelektrode (3), steuerbar sind, und im eingeschalteten Zustand die p-Basisschicht (7) mit einem Kathodenkontakt (1) kurzschliessen; wobei

(c) die p-Basisschicht (7) mit dem Draingebiet über einen Drainkontakt (11) verbunden ist, und das Sourcegebiet (4) ein Teil der mit dem Kathodenkontakt (1) in Verbindung stehenden n-Emitterschicht (5) ist; dadurch gekennzeichnet, dass

(d) zwischen dem Sourcegebiet (4) und dem Drainkontakt (11) ein kombiniertes Kanal-Drain-Gebiet (13) in Form einer n-dotierten Zone angeordnet ist.

2. Thyristor nach Anspruch 1, dadurch gekennzeichnet, dass die n-Dotierung des kombinierten Kanal-Drain-Gebiets (13) so gewählt ist, dass das Gebiet bei einer bestimmten an der Gateelektrode (3) anliegenden Spannung in seiner gesamten Tiefe ausgeräumt werden kann.

3. Thyristor nach Anspruch 2, dadurch gekennzeichnet, dass die n-Dotierung des kombinierten Kanal-Drain-Gebiets (13) im Konzentrationsbereich von $10^{17}$ cm$^{-3}$ liegt.

4. Thyristor nach Anspruch 1, dadurch gekennzeichnet, dass der Drainkontakt (11) aus einem Silizid besteht.

**Claims**

1. An MOS-controlled thyristor (MCT) having an anode (A) and a cathode (K), comprising

a) a sequence of variously doped layers containing a p-type emitter layer (9), an n-type base layer (8), a p-type base layer (7) and an n-type emitter layer (5) between the anode (A) and the cathode (K); and

b) a plurality of cathode short-circuits on the cathode side which can each be controlled via a MOSFET structure having a source region (4), a channel region, a drain region and an insulated gate electrode (3) and which short-circuit the p-type base layer (7) to a cathode contact (1) in the switched-on state;

c) the p-type base layer (7) being connected to the drain region via a drain contact (11) and the source region (4) being a part of the n-type emitter layer (5) which is in communication with the cathode contact (1);

characterized in that

d) a combined channel-drain region (13) in the form of an n-doped zone is disposed between the source region (4) and the drain contact (11).

2. Thyristor according to claim 1, characterized in that the n-doping of the combined channel-drain region (13) is so chosen that the region can be depleted throughout its entire depth if a certain voltage is applied to the gate electrode (3).

3. Thyristor according to claim 2, characterized in that the n-doping of the combined channel-drain region (13) is in the region of concentration of $10^{17}$ cm$^{-3}$.

4. Thyristor according to claim 4, characterized in that the drain contact (11) is composed of a silicide.

**Revendications**

1. Thyristor commandé par MOS (MCT) comportant une anode (A) et une cathode (K), comprenant :

(a) entre l'anode (A) et la cathode (K), une succession de couches à dopages différents, en l'occurrence une couche d'émetteur p (9), une couche de base n (8), une couche de base p (7) et une couche d'émetteur n (5), et

(b) du côté de la cathode, une pluralité de court-circuits de cathode qui peuvent être commandés chacun par l'intermédiaire d'une structure de MOSFET comprenant un domaine de source (4), un domaine de canal, un domaine de drain et une électrode de gâchette isolée (3), et qui, dans l'état conducteur, court-circuitent la couche de base p (7) par un contact de cathode (1),

(c) la couche de base p (7) étant connectée, par l'intermédiaire d'un contact de drain (11), au domaine de drain et le domaine de source (4) faisant partie de la couche d'émetteur n (5) qui est reliée au contact de cathode (1),

caractérisé en ce que :

(d) entre le domaine de source (4) et le contact de drain (11) est disposé un domaine de canal-drain combiné (13) ayant la forme d'une zone à dopage n.

2. Thyristor suivant la revendication 1, caractérisé en ce que le dopage n du domaine de canal-drain combiné (13) est choisi de telle façon que le domaine puisse être déchargé dans la totalité de sa profondeur lors d'une tension déterminée appliquée à l'électrode de gâchette (3).

3. Thyristor suivant la revendication 2, caractérisé en ce que le dopage n du domaine de-canal-drain combiné (13) se situe dans la zone de concentration de $10^{17}$ cm$^{-3}$.

4. Thyristor suivant la revendication 1, caractérisé en ce que le contact de drain (11) est en un siliciure.

FIG.1

FIG.2

FIG.3

FIG.4

EP 0 331 892 B1